# FASCICULE DE BREVET EUROPEEN

(11) **EP 3 479 385 B1**
(45) Date de publication et mention de la délivrance du brevet: **07.09.2022**
(21) Numéro de dépôt: 17742496.7
(22) Date de dépôt: 29.06.2017
(51) Int. Cl.: H01B 3/20, C11C 3/00, H01F 27/12, H01F 27/32, H01F 38/12

(54) **FLUIDE DIELECTRIQUE COMPRENANT DES ESTERS D'ACIDES GRAS**
DIELEKTRISCHES FLUID MIT FETTSÄUREESTERN
DIELECTRIC FLUID COMPRISING FATTY ACID ESTERS

(30) Priorité: 29.06.2016 FR 1656072
(43) Date de publication de la demande: 08.05.2019
(73) Titulaire: Arkema France, 92700 Colombes (FR)
(72) Inventeur: LEBRUN, Stéphanie, 27550 Nassandres (FR); MANDON, Frédéric, 60270 Gouvieux (FR); LENOIR, Romain, 92250 La Garenne Colombes (FR)
(74) Mandataire: Bandpay & Greuter
(86) Numéro de dépôt international: PCT/FR2017/051737
(87) Numéro de publication internationale: WO 2018/002529

(56) Documents cités:
- EP-A1- 1 623 785
- EP-A1- 1 662 513
- WO-A1-2007/041785
- WO-A1-2013/043311
- WO-A2-2004/108871

## Description

### DOMAINE DE L'INVENTION

La présente invention concerne l'utilisation d'une composition à base d'esters méthyliques d'acides gras d'huile de ricin en tant que fluide diélectrique dans divers appareils électriques tels que les transformateurs et condensateurs.

### ARRIERE-PLAN TECHNIQUE

De nombreux appareils électriques comme des condensateurs et des transformateurs contiennent un fluide diélectrique (ou isolant). Ce fluide a pour fonction d'isoler les composants à haute tension des autres pièces de l'appareil, ainsi que de transporter la chaleur vers l'environnement de sorte à refroidir l'appareil.

Il est connu d'utiliser des huiles minérales en tant que fluides diélectriques dans ces applications. Par ailleurs, dans un effort de réduction de l'impact environnemental des fluides diélectriques, des compositions à base d'huiles végétales ont également été proposées. Elles sont généralement formulées avec des additifs de type antioxydants permettant d'améliorer la stabilité à l'oxydation du fluide.

Ainsi, le document US 2002/027219 décrit une composition d'huile riche en acide oléique utile comme fluide d'isolation électrique, adaptée aux appareils électriques en combinaison avec plusieurs additifs de type antioxydants, additifs d'abaissement du point d'écoulement et désactivateurs de cuivre.

Le document US 2008/283803 décrit une composition de fluide diélectrique comprenant une huile végétale prétraitée (à savoir raffinée, blanchie et désodorisée), un ou plusieurs composés antioxydants et un ou plusieurs agents abaissant le point d'écoulement.

Des fluides diélectriques contenant des composés esters sont également connus.

Ainsi, le document WO 2012/001043 propose un additif dérivé par exemple de l'acide oléique, modifié par réaction avec un composé de type chloroformate d'isopropyle, pour les huiles diélectriques. Des avantages en termes de réduction de la viscosité, de stabilité à l'oxydation, d'augmentation de la permittivité et de réduction du point d'écoulement sont évoqués.

Le document US 2014/252281 concerne l'utilisation d'un ester synthétique de type méthyl-12-hydroxyméthyl-stearate fonctionnalisé, obtenu par hydroformylation et hydrogénation de l'acide oléique.

Le document US 2015/0228373 décrit l'utilisation d'esters synthétiques avec un ou plusieurs additifs (antioxydants, désactivateurs métalliques et agents d'abaissement du point d'écoulement) en tant que fluides diélectriques dans les appareils électriques. Les esters synthétiques sont préparés en faisant réagir du pentaérythritol avec certains acides carboxyliques déterminés.

Par ailleurs, le document EP 1623785 décrit l'utilisation d'esters méthyliques et éthyliques d'acides gras, principalement à base d'acide oléique, comme fluide diélectrique dans une application totalement différente, à savoir l'usinage par électroérosion et plus particulièrement les machines à décharge électrique (EDM). Dans cette application, l'outil d'usinage et la pièce usinée sont plongés dans un fluide diélectrique.

Il existe un besoin de fournir des compositions de fluides diélectriques pour appareils électriques tels que les condensateurs et transformateurs, à faible impact environnemental et présentant des performances élevées d'isolation électrique, en particulier en termes de tension de claquage.

### RESUME DE L'INVENTION

L'invention concerne en premier lieu l'utilisation d'une composition comprenant un mélange d'esters méthyliques d'acides gras d'huile de ricin en tant que fluide diélectrique dans un appareil électrique.

Selon un mode de réalisation, l'appareil électrique est choisi parmi les transformateurs, les condensateurs et les câbles électriques.

Selon un mode de réalisation, le mélange d'esters d'acides gras d'huile végétale comprend :
- du stéarate de méthyle, de préférence dans une teneur massique de 1 à 20 %, de préférence encore de moins de 15 %; et/ou
- de l'oléate de méthyle, de préférence dans une teneur massique de 1 à 90 %, de préférence encore de 25 à 35 % ; et/ou
- du linoléate de méthyle, de préférence dans une teneur massique de 1 à 80 %, de préférence encore de 35 à 45 % ; et/ou
- du palmitate de méthyle, de préférence dans une teneur massique de 1 à 50 %, de préférence de moins de 10 % ; et/ou
- du ricinoléate de méthyle, de préférence dans une teneur massique de 0 à 4 %, de préférence encore de 2 à 3 % ; et/ou
- de l'acide 10-undécylénique, de préférence dans une teneur massique de 0 à 1%.

Selon un mode de réalisation, la composition consiste essentiellement, voire consiste, en le mélange d'esters méthyliques d'acides gras d'huile de ricin.

Selon un mode de réalisation, la composition comprend un additif abaisseur du point d'écoulement, de préférence dans une proportion massique de 0,1 à 5 %, de préférence de 1 à 2 %.

Selon un mode de réalisation, la composition consiste essentiellement, voire consiste, en le mélange d'esters méthyliques d'acides gras d'huile de ricin et l'additif abaisseur du point d'écoulement.

Selon un mode de réalisation, l'additif abaisseur du point d'écoulement est un polymère acrylique dissout dans une huile.

L'invention concerne également un appareil électrique comportant une enceinte contenant une composition comprenant un mélange d'esters méthyliques d'acides gras d'huile de ricin tant que fluide diélectrique.

Selon un mode de réalisation, l'appareil électrique est choisi parmi les transformateurs, les condensateurs et les câbles électriques.

Selon un mode de réalisation, la composition dans l'appareil électrique est telle que décrite ci-dessus.

La présente invention permet de surmonter les inconvénients de l'état de la technique. Elle fournit plus particulièrement des compositions de fluides diélectriques pour appareils électriques tels que les condensateurs et transformateurs, à faible impact environnemental et présentant des performances élevées d'isolation électrique.

Cela est accompli grâce à la fourniture de compositions à base d'esters méthyliques d'acides gras obtenus par transestérification d'huile de ricin.

Dans certains modes de réalisation avantageux de l'invention :
- les compositions selon l'invention présentent une tension de claquage élevée, supérieure à la spécification minimale demandée par la norme CEI 62770 ;

- les compositions selon l'invention peuvent être produites facilement et pour un coût modéré ;
- les compositions selon l'invention présentent une faible viscosité ;
- les compositions selon l'invention présentent une bonne biodégradabilité ;
- les compositions selon l'invention peuvent contenir peu ou pas d'additifs (coûteux, toxiques et non biodégradables) tels que les antioxydants ou les désactivateurs de métaux couramment utilisés dans les formulations de l'état de la technique.

### DESCRIPTION DE MODES DE REALISATION DE L'INVENTION

L'invention est maintenant décrite plus en détail et de façon non limitative dans la description qui suit.

L'invention concerne l'utilisation d'une composition comprenant un mélange d'esters méthyliques d'acides gras d'huile de ricin, en tant que fluide diélectrique dans un appareil électrique.

Ce mélange d'esters méthyliques d'acides gras d'huile de ricin est un mélange qui peut être obtenu par transestérification d'une huile de ricin avec un alcool, de préférence un alcool linéaire, de préférence encore un alcool linéaire de C1 à C5, de préférence de C1 à C2.

Des alcools possibles sont le méthanol, l'éthanol, le propanol, le butan-1-ol, le butan-2-ol, le 2-méthylpropan-1-ol, le 2-méthylpropan-2-ol, le pentan-1-ol, le pentan-2-ol, le pentan-3-ol, le 2-méthylbutan-1-ol, le 2-méthylbutan-2-ol, le 3-méthylbutan-2-ol, le 3-méthylbutan-1-ol, et le 2,2-diméthylpropan-1-ol.

Un mélange des alcools ci-dessus peut également être utilisé. Selon l'invention, l'alcool comprend du méthanol. De préférence encore, uniquement du méthanol est utilisé.

Le taux de transestérification du mélange n'est pas nécessairement de 100 %, ce qui signifie que le mélange d'esters en question peut comprendre une certaine proportion d'acides gras non estérifiés.

L'huile de ricin peut être prétraitée avant l'étape de transestérification. Toutefois, de préférence, elle n'est pas prétraitée avant cette étape. Elle peut avantageusement subir une étape de post-traitement après la transestérification, telle qu'une purification par distillation.

Le mélange d'esters d'acides gras concerné par la présente invention est issu d'acides gras qui sont saturés et insaturés, et ont de préférence des longueurs de chaine comprises entre C8 et C26, de préférence entre C10 et C22 ; ces acides gras incluent préférentiellement les acides palmitique (C16), stéarique (C18) oléique (C18:1) et linoléique (C18:2).

Selon un mode de réalisation, le mélange d'esters méthyliques d'acides gras d'huile de ricin comprend de l'oléate de méthyle (C18:1), de préférence dans une teneur massique de 1 à 90%, de préférence de 20 à 40 %, de préférence encore de 25 à 35 %.

Selon un mode de réalisation, le mélange d'esters méthyliques d'acides gras d'huile de ricin comprend du linoléate de méthyle (C18:2), de préférence dans une teneur massique de 1 à 80%, de préférence de 30 à 50 %, de préférence encore de 35 à 45 %.

Selon un mode de réalisation, le mélange d'esters méthyliques d'acides gras d'huile de ricin comprend du stéarate de méthyle (C18:0), de préférence dans une teneur massique de 1 à 20 %, de préférence de 5 à 20 %, de préférence encore de moins de 6 à 15 % et plus préférentiellement de 8 à 12 %.

Selon un mode de réalisation, le mélange d'esters méthyliques d'acides gras d'huile de ricin comprend du palmitate de méthyle (C16:0), de préférence dans une teneur massique de 1 à 50%, de préférence dans une teneur massique de moins de 10%, et de préférence encore de moins de 8,5 %.

Selon un mode de réalisation, le mélange d'esters méthyliques d'acides gras d'huile de ricin comprend du ricinoléate de méthyle (C18:1(OH)), de préférence dans une teneur massique de 0% à 4 %, de préférence encore de 1,5 à 4 % et en particulier de 2 à 3 %.

Selon un mode de réalisation, le mélange d'esters méthyliques d'acides gras d'huile de ricin comprend de l'acide 10-undécylénique (C11:1), de préférence dans une teneur massique de 0 à 1,5 %, de préférence encore de 0,4 à 1,2 % et en particulier de 0,6 à 1 %.

Un tel produit est notamment commercialisé par la société Arkema sous la désignation Oleris^{®} Esterol A.

Selon un mode de réalisation, le mélange d'esters méthyliques d'acides gras d'huile de ricin comprend à la fois du stéarate de méthyle, de l'oléate de méthyle, du linoléate de méthyle, du palmitate de méthyle, et peut contenir du ricinoléate de méthyle et de l'acide 10-undécylénique, de préférence dans les teneurs massiques indiquées ci-dessus.

Selon un mode de réalisation, la composition de l'invention est dépourvue d'additif abaisseur du point d'écoulement.

Selon un mode de réalisation alternatif, la composition de l'invention comprend un additif abaisseur du point d'écoulement.

L'additif abaisseur du point d'écoulement est de préférence sélectionné de telle sorte qu'il permet d'abaisser le point d'écoulement de la composition selon l'invention en-dessous de 0°C (de préférence en-dessous de -1°C, ou -2°C, ou -3°C, ou -4°C, ou -5°C, ou -6°C, ou -7°C, ou -8°C, ou -9°C, selon la norme ASTM D97).

Les abaisseurs de point d'écoulement appropriés comprennent les polymères acryliques (ce qui inclut les copolymères acryliques), de préférence un polyalkylméthacrylate. Un additif particulièrement approprié est le produit commercialisé par Evonik sous la référence VISCOPLEX^{®} 1-211.

L'additif peut être présent dans la composition dans une proportion massique de 0,1 à 5 %, et de préférence de 1 à 2 %.

Un mélange d'esters (méthyliques) d'acides gras d'huile de ricin additivé d'un tel additif abaisseur du point d'écoulement est notamment commercialisé par la société Arkema sous la désignation Oleris^{®} Esterol F.

Selon un mode de réalisation, la composition de l'invention peut comprendre d'autres composés diélectriques ou divers additifs, tels que des antioxydants ou des désactivateurs métalliques.

Toutefois, il est préféré que la composition de l'invention soit essentiellement dépourvue, voire totalement dépourvue, de tels composés et additifs.

En particulier, selon un mode de réalisation, la composition de l'invention est essentiellement dépourvue ou totalement dépourvue d'antioxydant.

Selon un mode de réalisation, la composition de l'invention est essentiellement dépourvue ou totalement dépourvue de désactivateur métallique.

Selon un mode de réalisation, la composition de l'invention consiste essentiellement en le mélange d'esters méthyliques d'acides gras d'huile de ricin et, le cas échéant l'additif abaisseur du point d'écoulement décrit ci-dessus. Selon un autre mode de réalisation, la composition consiste en le mélange d'esters méthyliques d'acides gras d'huile de ricin et, le cas échéant, l'additif abaisseur du point d'écoulement.

### EXEMPLES

Les exemples suivants illustrent l'invention sans la limiter.

Diverses propriétés importantes pour une utilisation en tant que fluide diélectrique ont été déterminées sur les produits commercialisés par Arkema sous les références Oleris^{®} Esterol A et F, qui sont des compositions conformes à l'invention.

Les résultats sont résumés dans le tableau ci-dessous. Les seuils exigés sont issus de la norme CEI 62770.

| **Propriété** | **Méthode d'essai** | **Seuil** | **Oleris^{®} Esterol A** | **Oleris^{®} Esterol F** |
|---|---|---|---|---|
| Viscosité à 40 °C | ISO 3104 | Max. 18 mm²s⁻¹ | < 5 mm²s⁻¹ | < 10 mm²s⁻¹ |
| Tension de claquage | CEI 60156 | Min. 35 kV | 78 kV | 76 kV |
| Point de feu | ISO 2592 (vase ouvert) | Min. 175°C | 198°C | 192°C |
| Point d'éclair | ISO 3679 (vase clos) | Min. 135°C | 173°C | 167°C |
| Biodégradation | US EPA OCDE 301 B | Facilement biodégradable | Facilement biodégradable 75% après 28 jours | Facilement biodégradable 75% après 28 jours |

En plus de présenter des valeurs de tension de claquage très significativement supérieures à la spécification minimale de 35 kV, les deux produits sont conformes au niveau des critères physique (viscosité à 40°C) et de sécurité (point de feu ≥ 175°C, point éclair ≥ 135°C) et sont facilement biodégradables.

Les tensions de claquage ont alors été comparées avec celles d'autres produits sur base végétale, contenant des triglycérides et des additifs (antioxydants et/ou désactivateurs de métaux).

La composition de l'exemple comparatif 1 contient plus de 98,5% d'huile de soja, moins de 1% d'antioxydant, moins de % d'abaisseur de point d'écoulement et moins de 1% de colorant.

La composition de l'exemple comparatif 2 contient 98,4% d'huile de tournesol avec une forte teneur en acide oléique et 1,6% d'antioxydants et de désactivateur de métaux.

| **Produit** | **Oleris^{®} Esterol A** | **Oleris^{®} Esterol F** | **Exemple comparatif 1** | **Exemple comparatif 2** |
|---|---|---|---|---|
| Tension de claquage (kV) | 78 | 76 | 47 | 45 |

Les produits Oleris^{®} Esterol A et F, en plus de leur faible viscosité, de leur biodégradabilité, de leur origine végétale, et de l'absence d'antioxydant et de désactivateur de métaux dans leur composition, présentent donc des tensions de claquage intrinsèques bien supérieures à celles de fluides diélectriques à base d'huile végétale et formulés avec des additifs.

## Revendications

1. Utilisation d'une composition comprenant un mélange d'esters méthyliques d'acides gras d'huile de ricin en tant que fluide diélectrique dans un appareil électrique.

2. Utilisation selon la revendication 1, dans laquelle l'appareil électrique est choisi parmi les transformateurs, les condensateurs et les câbles électriques.

3. Utilisation selon l'une des revendications 1 à 2, dans laquelle le mélange d'esters méthyliques d'acides gras d'huile de ricin comprend :
- du stéarate de méthyle, de préférence dans une teneur massique de 1 à 20 %, de préférence encore de moins de 15 %; et/ou
- de l'oléate de méthyle, de préférence dans une teneur massique de 1 à 90 %, de préférence encore de 25 à 35 % ; et/ou
- du linoléate de méthyle, de préférence dans une teneur massique de 1 à 80 %, de préférence encore de 35 à 45 % ; et/ou
- du palmitate de méthyle, de préférence dans une teneur massique de 1 à 50 %, de préférence de moins de 10 % ; et/ou
- du ricinoléate de méthyle, de préférence dans une teneur massique de 0 à 4 %, de préférence encore de 2 à 3 % ; et/ou
- de l'acide 10-undécylénique, de préférence dans une teneur massique de 0 à 1%.

4. Utilisation selon l'une des revendications 1 à 3, dans laquelle la composition consiste essentiellement, voire consiste, en le mélange d'esters méthyliques d'acides gras d'huile de ricin.

5. Utilisation selon l'une des revendications 1 à 3, dans laquelle la composition comprend un additif abaisseur du point d'écoulement, de préférence dans une proportion massique de 0,1 à 5 %, de préférence de 1 à 2 %.

6. Utilisation selon la revendication 5, dans laquelle la composition consiste essentiellement, voire consiste, en le mélange d'esters méthyliques d'acides gras d'huile de ricin et l'additif abaisseur du point d'écoulement.

7. Utilisation selon l'une des revendications 5 à 6, dans laquelle l'additif abaisseur du point d'écoulement est un polymère acrylique dissout dans une huile.

8. Appareil électrique comportant une enceinte contenant une composition comprenant un mélange d'esters méthyliques d'acides gras d'huile de ricin en tant que fluide diélectrique.

9. Appareil électrique selon la revendication 8, qui est choisi parmi les transformateurs, les condensateurs et les câbles électriques.

10. Appareil électrique selon la revendication 8 ou 9, dans lequel la composition est telle que décrite dans les revendications 3 à 7.

## Patentansprüche

1. Verwendung einer Zusammensetzung, die ein Gemisch aus Rizinusöl-Fettsäuremethylestern als dielektrisches Fluid in einem elektrischen Gerät umfasst.

2. Verwendung nach Anspruch 1, wobei das elektrische Gerät aus den Transformatoren, den Kondensatoren und den elektrischen Kabeln ausgewählt ist.

3. Verwendung nach einem der Ansprüche 1 bis 2, wobei das Gemisch aus Rizinusöl-Fettsäuremethylestern umfasst:
- Methylstearat, vorzugsweise in einem Massengehalt von 1 bis 20 %, vorzugsweise noch unter 15 %; und/oder
- Methyloleat, vorzugsweise in einem Massengehalt von 1 bis 90 %, vorzugsweise noch von 25 bis 35 %; und/oder
- Methyllinoleat, vorzugsweise in einem Massengehalt von 1 bis 80 %, vorzugsweise noch von 35 bis 45 %; und/oder
- Methylpalmitat, vorzugsweise in einem Massengehalt von 1 bis 50 %, vorzugsweise unter 10 %; und/oder
- Methyricinoleat, vorzugsweise in einem Massengehalt von 0 bis 4 %, vorzugsweise noch von 2 bis 3 %; und/oder
- 10-Undecylensäure, vorzugsweise in einem Massengehalt von 0 bis 1 %.

4. Verwendung nach einem der Ansprüche 1 bis 3, wobei die Zusammensetzung aus dem Gemisch aus Rizinusöl-Fettsäuremethylestern im Wesentlichen besteht, ja sogar besteht.

5. Verwendung nach einem der Ansprüche 1 bis 3, wobei die Zusammensetzung einen den Fließpunkt senkenden Zusatzstoff vorzugsweise in einem Massenverhältnis von 0,1 bis 5 %, vorzugsweise von 1 bis 2 % umfasst.

6. Verwendung nach Anspruch 5, wobei die Zusammensetzung aus dem Gemisch aus Rizinusöl-Fettsäuremethylestern und dem den Fließpunkt senkenden Zusatzstoff im Wesentlichen besteht, ja sogar besteht.

7. Verwendung nach einem der Ansprüche 5 bis 6, wobei der den Fließpunkt senkende Zusatzstoff ein in einem Öl gelöstes Acrylpolymer ist.

8. Elektrisches Gerät, umfassend einen Behälter, der eine Zusammensetzung enthält, die ein Gemisch aus Rizinusöl-Fettsäuremethylestern als dielektrisches Fluid umfasst.

9. Elektrisches Gerät nach Anspruch 8, das aus den Transformatoren, den Kondensatoren und den elektrischen Kabeln ausgewählt ist.

10. Elektrisches Gerät nach Anspruch 8 oder 9, wobei die Zusammensetzung ist, wie in den Ansprüchen 3 bis 7 beschrieben.

## Claims

1. Use of a composition comprising a mixture of castor oil fatty acid methyl esters as a dielectric fluid in an electrical device.

2. Use according to claim 1, wherein the electrical device is chosen from transformers, capacitors and electric cables.

3. Use according to one of the claims 1 to 2, wherein the mixture of castor oil fatty acid methyl esters comprises:
- methyl stearate, preferably in a mass content of 1 to 20%, more preferably less than 15%; and/or
- methyl oleate, preferably in a mass content of 1 to 90%, more preferably of 25 to 35%; and/or
- methyl linoleate, preferably in a mass content of 1 to 80%, more preferably of 35 to 45%; and/or
- methyl palmitate, preferably in a mass content of 1 to 50%, preferably less than 10%; and/or
- methyl ricinoleate, preferably in a mass content of 0 to 4%, more preferably of 2 to 3%; and/or
- 10-undecylenic acid, preferably in a mass content of 0 to 1%.

4. Use according to one of the claims 1 to 3, wherein the composition essentially consists, or even consists, of the mixture of castor oil fatty acid methyl esters.

5. Use according to one of the claims 1 to 3, wherein the composition comprises a pour point depressant additive, preferably in a mass proportion of 0.1 to 5%, preferably of 1 to 2%.

6. Use according to claim 5, wherein the composition essentially consists, or even consists, of the mixture of castor oil fatty acid methyl esters and the pour point depressant additive.

7. Use according to one of the claims 5 to 6, wherein the pour point depressant additive is an acrylic polymer dissolved in an oil.

8. Electrical device comprising an enclosure containing a composition comprising a mixture of castor oil fatty acid methyl esters as a dielectric fluid.

9. Electrical device according to claim 8, which is chosen from transformers, capacitors and electric cables.

10. Electrical device according to claim 8 or 9, wherein the composition is as described in claims 3 to 7.
